# EUROPEAN PATENT APPLICATION

(11) **EP 4 651 659 A1**
(43) Date of publication of application: **19.11.2025**
(21) Application number: 25176177.1
(22) Date of filing: 13.05.2025
(51) Int. Cl.: H05K 7/20

(54) **SERVER-LEVEL FILTRATION OF SECONDARY FLUID NETWORK FOR DIRECT-TO-CHIP COOLING**

(30) Priority: 14.05.2024 US 202463647551 P; 08.05.2025 US 202519202458
(71) Applicant: Vertiv Corporation, Westerville, OH 43082 (US)
(72) Inventor: WISE, Ashley Elizabeth, Westerville (US); TIPTON, Russell Charles, Westerville (US)
(74) Representative: Beal, James Michael

(57) **Abstract**

A rack server system includes a coolant distribution unit (CDU), a server enclosure containing a plurality of servers, a manifold coupled between the CDU and the servers, the manifold configured to distribute coolant flowed from the CDU to the servers, and a plurality of server-line filters coupled between the manifold and the plurality of servers.

## Description

### CROSS-REFERENCE TO RELATED APPLICATIONS

This application claims the benefit of U.S. Provisional Application No. 63/647,551, filed on May 14, 2024, and of U.S. Non-Provisional Application No. 19/202,458, filed on May 8, 2025.

### TECHNICAL FIELD

The present disclosure relates to systems and methods for cooling computing systems, for example, server computing systems such as rack servers.

### BACKGROUND

Servers (e.g., server computing systems, such as rack servers) typically include one or more types of cooling systems. Example cooling systems include air cooling systems, direct-to-chip (e.g., liquid-based) cooling systems, and combinations thereof. Cooling systems may further include filtration systems/devices, such as air filters, filter drier assemblies, etc.

### SUMMARY

A rack server system includes a coolant distribution unit (CDU), a server enclosure containing a plurality of servers, a manifold coupled between the CDU and the servers, the manifold configured to distribute coolant flowed from the CDU to the servers, and a plurality of server-line filters coupled between the manifold and the plurality of servers.

In other features, each of the server-line filters has a diameter of less than 50 mm and a length of less than 150 mm.

In other features, the system further includes a system-level filtration assembly coupled between the manifold and the CDU.

In other features, the system-level filtration assembly is a filter drier assembly.

In other features, the system further includes a plurality of server-level filtration assemblies. Each of the server-level filtration assemblies includes a respective server-line filter of the plurality of server-line filters and a quick disconnect coupling arranged between the respective server-line filter and the manifold.

In other features, each of the server-level filtration assemblies includes a bypass valve arranged in parallel with the respective server-line filter.

Further areas of applicability of the present disclosure will become apparent from the detailed description, the claims and the drawings. The detailed description and specific examples are intended for purposes of illustration only and are not intended to limit the scope of the disclosure.

### BRIEF DESCRIPTION OF THE DRAWINGS

The present disclosure will become more fully understood from the detailed description and the accompanying drawings, wherein:
FIGS. 1A, 1B, and 1C show an example rack server system including a plurality of servers and a coolant distribution unit according to the present disclosure;
FIG. 2 shows a functional block diagram of an example rack server system according to the present disclosure;
FIG. 3 shows an example server-level filtration system according to the present disclosure; and
FIG. 4 shows example quick disconnect couplings according to the present disclosure.

In the drawings, reference numbers may be reused to identify similar and/or identical elements.

### DETAILED DESCRIPTION

Servers (e.g., server computing systems, such as rack servers) typically include one or more types of cooling systems. Example cooling systems include air cooling systems, direct-to-chip (e.g., liquid-based) cooling systems, and combinations thereof. Cooling systems may further include filtration systems/devices, such as air filters, filter drier assemblies, etc.

Direct-to-chip cooling systems have an increased need for cleanliness (i.e., as compared to air cooling systems) and therefore require a highly capable and flexible filtration system. For example, contaminants as small as 50 microns threaten the basic functionality of direct-to-chip cooled systems. System-level filtration (e.g., within a cooling or coolant distribution unit, or CDU) may not protect all components/equipment of direct-to-chip cooling systems (e.g., evaporators) if contaminants are introduced between the CDU and the server. When new equipment enters a secondary fluid network (information technologies (IT) equipment, instrumentation such as flow meters or pressure transducers, on-site modifications of piping, etc.), additional risk for clogging (e.g., of cold plates) is introduced. As an example, liquid distribution components between the filter drier assembly and a cold plate evaporator are fabricated/assembled in-situ. At start-up commissioning, any residual particulates must flow through the cold plate evaporators prior to being captured at the filter drier assembly. Accordingly, larger particulates may be captured at the cold plate evaporator and potentially plug some flow passageways.

As direct-to-chip technology is rapidly developing (e.g., to accommodate complex processing technologies, such as artificial intelligence and machine learning (AI/ML) data clusters), protecting the health of servers and improving the confidence of cooling systems is critical.

Systems and methods according to the present disclosure are configured to implement one or more server-level filtration techniques. As used herein, "server-level" refers to filter structure implemented downstream of system-level filter structure (e.g., downstream of a filter drier assembly of the CDU, between the CDU and respective individual servers, etc.). In contrast, "system-level" refers to filter structure implemented at the CDU (e.g., such as a filter drier of the CDU configured to provide filtering for a plurality of servers. The addition of server-level filtration adds redundancy and therefore confidence in the cleanliness of the refrigerant entering each server, accelerator, etc. For example, filtration implemented immediately at the inlet to each server reduces likelihood of damage to components such as accelerators (e.g., processing accelerators). In some examples, implementation of server-level filtration in accordance with the principles of the present disclosure may reduce an overall size of the CDU, such as by eliminating the need for system-level filter filtration. In other examples, the server-level filtration is implemented in addition to the system-level filtration (e.g., in addition to a filter drier assembly of the CDU).

In some examples, the server-level filtration according to the present disclosure includes moisture-capturing media.

In some examples, system and methods according to the present disclosure are configured to monitor a pressure drop across a server-level filter assembly to measure a proportional level of dirtiness/cleanliness and provide an indication of a predictive schedule for filter replacement based on usage.

In some examples, server-level filtration systems and methods include one or more quick-connect/disconnect in-line filter components, couplings, etc. and/or hose assemblies as described below in more detail.

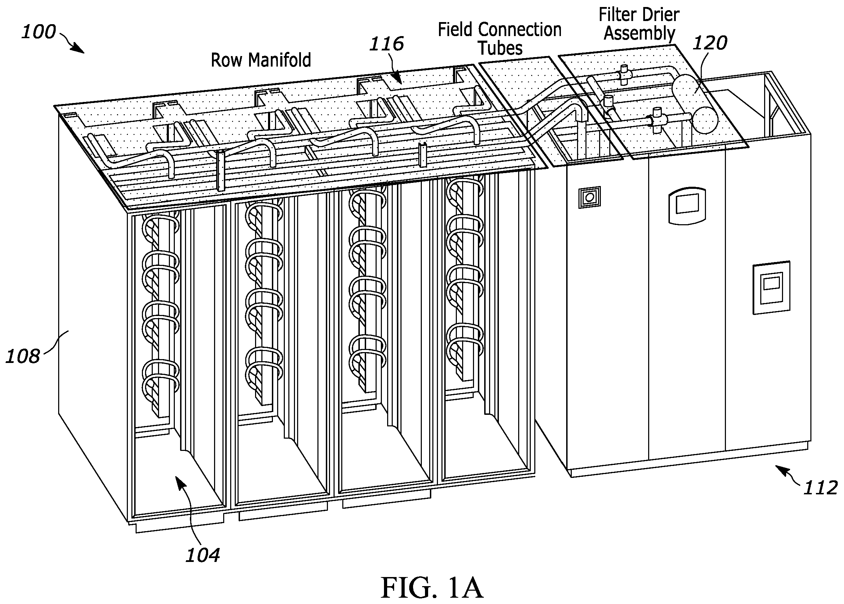

FIG. 1A shows an example rack server system 100 including a plurality of servers 104 (shown in phantom) housed within a rack enclosure 108. A coolant distribution unit (CDU) 112 (which may be housed within or arranged external to the rack enclosure 108) is configured to control flow of coolant to and from the servers 104 (e.g., via respective coolant supply lines or tubes of a manifold 116). Coolant (e.g., liquid refrigerant) flows from the manifold 116 into the servers 104 to absorb heat from respective cooling or cold plates and from the servers 104 back into the CDU 112. For example, the CDU 112 includes a heat exchanger configured to transfer/remove heat absorbed by the coolant.

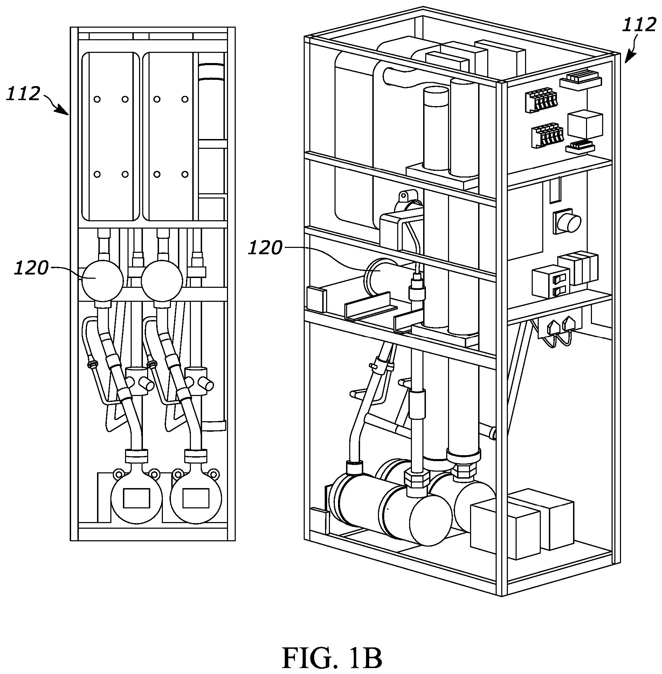

A filter drier assembly 120 is arranged between the CDU 112 and the servers 104 (i.e., upstream of the servers 104). In the example shown in FIG. 1A, the filter drier assembly 120 is arranged external to the CDU 112. In an example shown in FIG. 1B, multiple (e.g., two) of the filter drier assemblies 120 are arranged within the CDU 112. The filter drier assembly 120 is configured to filter particles and other impurities or contaminants from the coolant, and to remove moisture (e.g., water) from the coolant. For example, the filter drier assembly 120 includes filter media configured to remove contaminants and a desiccant material configured to remove moisture. However, contaminants introduced downstream of the filter drier assembly 120 (e.g., contaminants associated with components of the manifold 116, tubing, etc. that may be introduced subsequent to installation/assembly) may be contained in coolant initially flowing to the servers 104.

In some embodiments described below in more detail, the filtering portion of the filter drier assembly 120 may be implemented as one or more in-line filter assemblies for respective liquid supply lines to each of the servers 104, which may include a bypass line to allow non-stop operation during filter replacement.

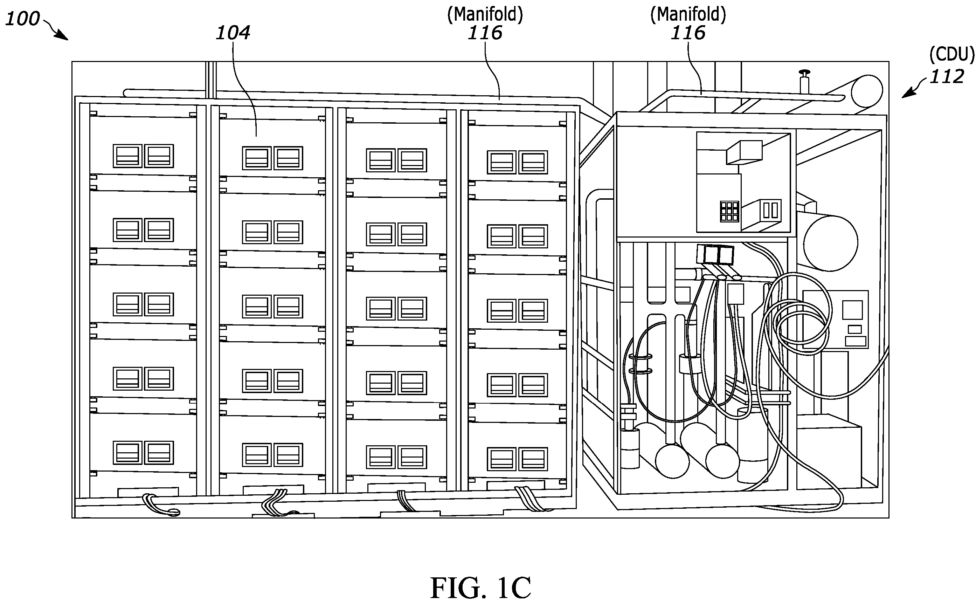

FIG. 1C shows another example implementation of the rack server system 100 populated with the servers 104.

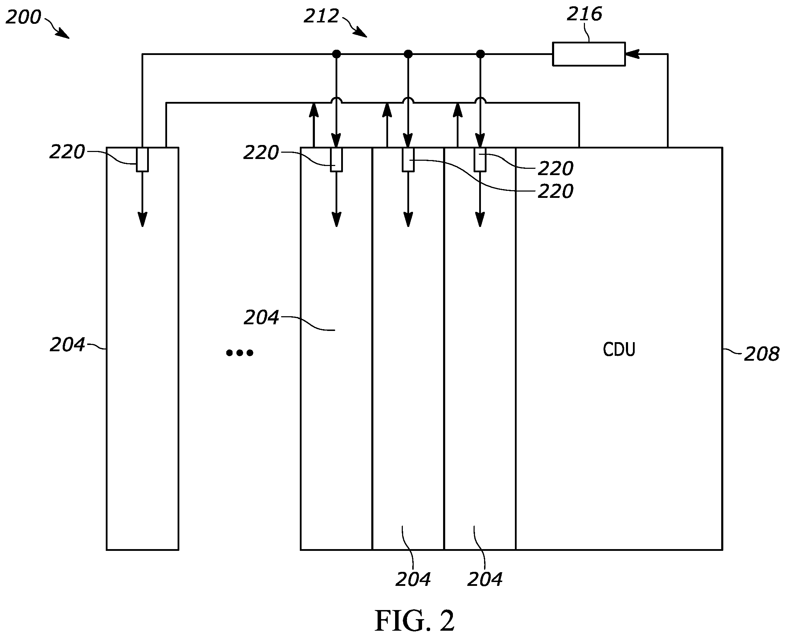

FIG. 2 shows a functional block diagram of an example rack server system 200 according to the present disclosure. Coolant flows and is distributed to a plurality of servers 204 from a CDU 208 (e.g., via a manifold 212). In some examples, as shown, the coolant flows from the CDU 208 through a system-level filtration device, such as a filter drier assembly 216. The filter drier assembly 216 may be arranged external to the CDU 208 (as shown), within the CDU 208, or, in some examples, the filter function may be implemented at the server level.

The system 200 includes one or more server-level filtration devices, such as server filters or assemblies (e.g., server-line filters) 220. As shown, the filter assemblies 220 are arranged within the respective servers 204. In other examples, one or more of the filter assemblies 220 may be arranged external to the servers 204 (e.g., at respective inlets of the servers 204, between the manifold 212 and the servers 204). As shown, each of the servers 204 has a respective filter assembly 220. In other examples, one filter drier assembly 220 may be coupled to two or more of the servers 204.

Accordingly, the server filter assemblies 220 provide filtering to remove contaminants introduced downstream of the CDU 208 (e.g., contaminants present prior to assembly of components downstream of the CDU 208 and the filter drier assembly 216, such as contaminants within the manifold 212 and related components).

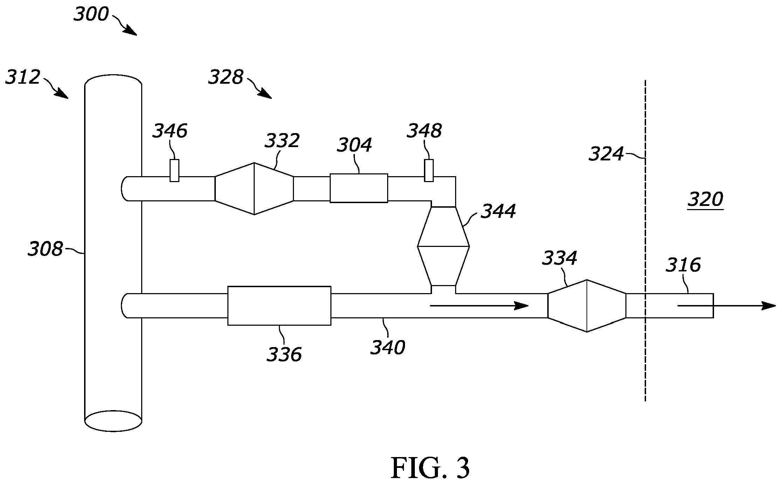

FIG. 3 shows an example server-level filtration assembly or system 300 according to the present disclosure. The system/assembly 300 includes a filter assembly (a server-line filter) 304 coupled between a coolant supply line 308 (e.g., of a manifold 312) and an inlet supply hose 316 of a server 320. As shown in this example, various components of the system 300 (e.g., the filter assembly 304) are located external to the sever 320 (e.g., external to a server housing or enclosure 324). In other examples, one or more components, such as the filter assembly 304, are located within the server 320.

The filter assembly 304 has a reduced size relative to typical filter assemblies. For example, the filter assembly 304 may have a diameter less than 50 millimeters (mm) and, in some examples, less than or equal to 25 millimeters. A length of the filter assembly 304 may be less than 150 millimeters and, in some examples, less than or equal to 50 millimeters. Further, the filter assembly 304 may include a removable filter element/media configured to filter contaminants smaller than 50 microns. In some examples, the filter media is configured to filter contaminants smaller than 30 microns (e.g., 25 microns and greater). In some examples, the filter media is configured to filter contaminants as small as 20 microns. In various embodiments, the filter assemblies may be comprised of metals or metal frits, and may include gasketing to be refrigerant compatible (i.e., comprised of materials such as PEEK, NYLON, PTFE, or neoprene. The filter assembly 304 is further configured to provide a flow rate of 1 to 4 liters per minute and has a pressure rating between 1.5 and 2.0 MPa (e.g., 1.75 MPa).

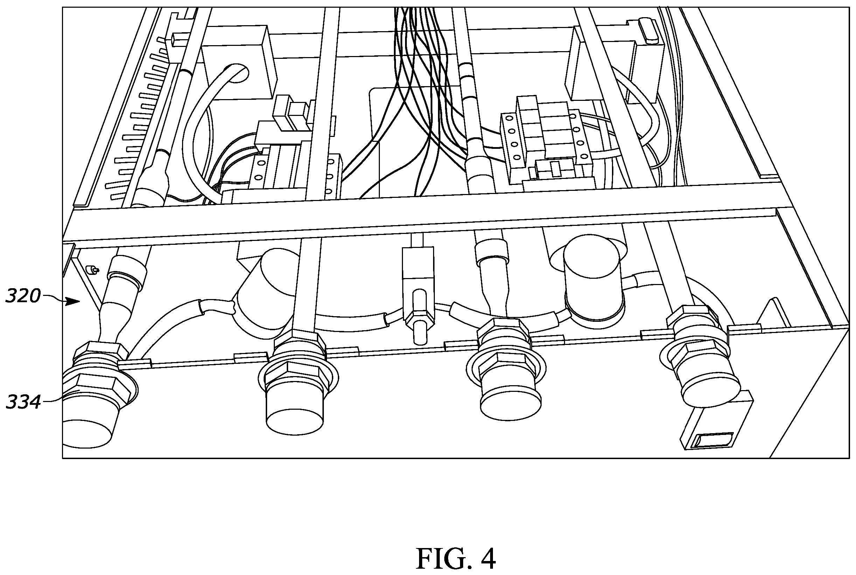

In an example (as shown), a server-level filter assembly 328 includes the filter assembly 304, one or more quick disconnect connector/couplings such as coupling 332 and coupling 334, a bypass valve (e.g., a 2-way ball valve) 336, and respective supply line/hose portions 340 between components. The bypass valve 336 may be turned on and off (e.g., manually) to facilitate cleaning/maintenance of the filter assembly 304 without interrupting flow of coolant to the server 320. For example, the bypass valve 336 may be normally off and selectively turned on prior to disconnecting the filter assembly 304 to be cleaned (e.g., to replace the filter media). In some examples, a quick disconnect coupling 344 facilitates the complete removal of the filter assembly 304 from the system 300. FIG. 4 shows an example server 320 having one or more of the quick disconnect couplings 334 configured to couple the server 320 to the server-level filter assembly 328.

In some embodiments, the couplings 332, 334, and 344 may be used to provide fast and easy connection and disconnection of fluid or air lines. These fittings are also known as quick connects or quick-release couplings, which are used to replace fitting connections that would require tools to assemble and disassemble. Such fittings may include a spring-loaded ball latching mechanism, which automatically locks the two halves of the fitting together when they are pushed together. To release the connection, the sleeve is pulled back and the balls are unloaded to release the connection. The quick disconnect advantage is that this can be done quickly and by hand. Another example utilizes male/female threaded ends that are manually tightened to engage spring-loaded seals with final tightening by wrenches.

In some examples, the filter assembly 328 includes one or more pressure ports 346, 348. The pressure ports 346, 348 may be used to monitor pressure and/or flow of coolant. For example, a pressure drop between the ports 346, 348 may be used to determine whether to clean or replace the filter media. Further, the pressure drop may be used to determine optimal filter media, minimize sub-cooling, optimize heat transfer, facilitate stable coolant flow, etc. In some examples, the system 300 may be configured to provide a notification (e.g., an alarm or other visual or audio indicator) in response to determining that cleaning or other maintenance is required.

Although described above with respect to pumped two-phase (refrigerant)-based systems, the principles of the present disclosure may also be implemented in pumped single-phase systems or other direct-to-chip cooling systems. In an example single-phase system, the coolant is aqueous-based, such as a 25% propylene glycol solution. One or more filter assemblies can be arranged at the CDU and piping/tubing from the CDU to the servers is fabricated and installed in-situ. Single-phase heat exchangers deployed at the CPU/GPU have similar geometry as heat exchangers for two-phase systems, such as 100 micron fin geometry. Startup/commissioning filtration for single-phase systems has the same challenge as pumped two-phase systems (i.e., contaminants introduced from the piping/tubing downstream of the filter assembly. Accordingly, single-phase systems may implement the server-level filter assemblies according to the present disclosure.

The foregoing description is merely illustrative in nature and is in no way intended to limit the disclosure, its application, or uses. The broad teachings of the disclosure can be implemented in a variety of forms. Therefore, while this disclosure includes particular examples, the true scope of the disclosure should not be so limited since other modifications will become apparent upon a study of the drawings, the specification, and the following claims. It should be understood that one or more steps within a method may be executed in different order (or concurrently) without altering the principles of the present disclosure. Further, although each of the embodiments is described above as having certain features, any one or more of those features described with respect to any embodiment of the disclosure can be implemented in and/or combined with features of any of the other embodiments, even if that combination is not explicitly described. In other words, the described embodiments are not mutually exclusive, and permutations of one or more embodiments with one another remain within the scope of this disclosure.

Spatial and functional relationships between elements (for example, between modules, circuit elements, semiconductor layers, etc.) are described using various terms, including "connected," "engaged," "coupled," "adjacent," "next to," "on top of," "above," "below," and "disposed." Unless explicitly described as being "direct," when a relationship between first and second elements is described in the above disclosure, that relationship can be a direct relationship where no other intervening elements are present between the first and second elements, but can also be an indirect relationship where one or more intervening elements are present (either spatially or functionally) between the first and second elements. As used herein, the phrase at least one of A, B, and C should be construed to mean a logical (A OR B OR C), using a non-exclusive logical OR, and should not be construed to mean "at least one of A, at least one of B, and at least one of C."

In the figures, the direction of an arrow, as indicated by the arrowhead, generally demonstrates the flow of information (such as data or instructions) that is of interest to the illustration. For example, when element A and element B exchange a variety of information but information transmitted from element A to element B is relevant to the illustration, the arrow may point from element A to element B. This unidirectional arrow does not imply that no other information is transmitted from element B to element A. Further, for information sent from element A to element B, element B may send requests for, or receipt acknowledgements of, the information to element A.

The apparatuses and methods described in this application may be partially or fully implemented by a special purpose computer created by configuring a general purpose computer to execute one or more particular functions embodied in computer programs. The functional blocks, flowchart components, and other elements described above serve as software specifications, which can be translated into the computer programs by the routine work of a skilled technician or programmer.

The disclosure comprises the following items:
1. A rack server system, comprising:
   a coolant distribution unit (CDU);
   a server enclosure containing a plurality of servers;
   a manifold coupled between the CDU and the servers, the manifold configured to distribute coolant flowed from the CDU to the servers; and
   a plurality of server-line filters coupled between the manifold and the plurality of servers.
2. The rack server system of item 1, wherein each of the server-line filters has a diameter of less than 50 mm and a length of less than 150 mm.
3. The rack server system of item 1 or item 2, further comprising a system-level filtration assembly coupled between the manifold and the CDU.
4. The rack server system of any preceding item, wherein the system-level filtration assembly is a filter drier assembly.
5. The rack server system of any preceding item, wherein the plurality of server-line filters is located downstream of the filter drier assembly, between the filter drier assembly and the plurality of servers.
6. The rack server system of any preceding item, further comprising a plurality of server-level filtration assemblies, wherein each of the server-level filtration assemblies includes:
   a respective server-line filter of the plurality of server-line filters; and
   a quick disconnect coupling arranged between the respective server-line filter and the manifold.
7. The rack server system of any preceding item, wherein each of the server-level filtration assemblies includes a bypass valve arranged in parallel with the respective server-line filter.
8. A direct-to-chip cooling system comprising the rack server system of any preceding item.
9. The rack server system of any preceding item, wherein the plurality of server-line filters includes moisture-capturing media.
10. The rack server system of any preceding item, further comprising at least one pressure port.
11. The rack server system of any preceding item, wherein the pressure port is configured to provide an indication of a pressure drop.
12. The rack server system of any preceding item, further comprising a plurality of server-level filtration assemblies, wherein each of the server-level filtration assemblies includes:
   a respective server-line filter coupled between a coolant supply line and an inlet supply hose of a respective server of the plurality of servers; and
   a bypass valve arranged in parallel with the respective server-line filter between the coolant supply line and the inlet supply hose.
13. The rack server system of any preceding item, wherein the respective server-line filter is arranged external to a server housing of the respective server.
14. A direct-to-chip, rack server cooling system, comprising:
   a coolant distribution unit (CDU);
   a server enclosure containing a plurality of servers;
   a manifold coupled between the CDU and the servers, the manifold configured to distribute coolant flowed from the CDU to the plurality of servers; and
   a plurality of server-level filtration assemblies coupled between the manifold and the plurality of servers,
   wherein each of the plurality of server-level filtration assemblies includes:
      a server-line filter coupled between a coolant supply line of the manifold and an inlet supply hose of a respective server of the plurality of servers; and
      a bypass valve arranged in parallel with the server-line filter between the coolant supply line and the inlet supply hose.
15. The rack server cooling system of item 14, wherein the server-line filter is arranged external to a server housing of the respective server.
16. The rack server cooling system of item 14 or item 15, further comprising a system-level filtration assembly coupled between the manifold and the CDU, wherein the plurality of server-level filtration assemblies is located downstream of the system-level filtration assembly, between the system-level filtration assembly and the plurality of servers.
17. The rack server cooling system of any of items 14-16, wherein each of the plurality of server-level filtration assemblies includes:
   a first quick disconnect coupling arranged between the coolant supply line and the server-line filter; and
   a second quick disconnect coupling arranged between the server-line filter and the inlet supply hose.
18. The rack server cooling system of any of items 14-17, further comprising a third quick disconnect coupling arranged between the second quick disconnect coupling and the inlet supply hose.
19. The rack server cooling system of any of items 14-18, further comprising a first pressure port arranged between the coolant supply line and the server-line filter and a second pressure port arranged between the server-line filter and the inlet supply hose.
20. The rack server cooling system of any of items 14-19, wherein the server-line filter has a diameter of less than 50 mm and a length of less than 150 mm.

## Claims

1. A rack server system, comprising:
a coolant distribution unit, CDU;
a server enclosure containing a plurality of servers;
a manifold coupled between the CDU and the servers, the manifold configured to distribute coolant flowed from the CDU to the servers; and
a plurality of server-line filters coupled between the manifold and the plurality of servers.

2. The rack server system of claim 1, wherein each of the server-line filters has a diameter of less than 50 mm and a length of less than 150 mm.

3. The rack server system of claim 1 or claim 2, further comprising a system-level filtration assembly coupled between the manifold and the CDU.

4. The rack server system of claim 3, wherein the system-level filtration assembly is a filter drier assembly.

5. The rack server system of claim 4, wherein the plurality of server-line filters is located downstream of the filter drier assembly, between the filter drier assembly and the plurality of servers.

6. The rack server system of any preceding claim, further comprising a plurality of server-level filtration assemblies, wherein each of the server-level filtration assemblies includes:
a respective server-line filter of the plurality of server-line filters; and
a quick disconnect coupling arranged between the respective server-line filter and the manifold.

7. The rack server system of claim 6, wherein each of the server-level filtration assemblies includes a bypass valve arranged in parallel with the respective server-line filter.

8. A direct-to-chip cooling system comprising the rack server system of any preceding claim.

9. The rack server system of any preceding claim, wherein the plurality of server-line filters includes moisture-capturing media.

10. The rack server system of any preceding claim, further comprising at least one pressure port, and optionally wherein the pressure port is configured to provide an indication of a pressure drop.

11. The rack server system of any of claims 1-5, further comprising a plurality of server-level filtration assemblies, wherein each of the server-level filtration assemblies includes:
a respective server-line filter coupled between a coolant supply line and an inlet supply hose of a respective server of the plurality of servers; and
a bypass valve arranged in parallel with the respective server-line filter between the coolant supply line and the inlet supply hose.

12. The rack server system of claim 11, wherein the respective server-line filter is arranged external to a server housing of the respective server.

13. The rack server cooling system of claim 11 or claim 12, wherein each of the plurality of server-level filtration assemblies includes:
a first quick disconnect coupling arranged between the coolant supply line and the server-line filter; and
a second quick disconnect coupling arranged between the server-line filter and the inlet supply hose.

14. The rack server cooling system of claim 13, further comprising a third quick disconnect coupling arranged between the second quick disconnect coupling and the inlet supply hose.

15. The rack server cooling system of claim 13 or claim 14, further comprising a first pressure port arranged between the coolant supply line and the server-line filter and a second pressure port arranged between the server-line filter and the inlet supply hose.
